# EUROPEAN PATENT SPECIFICATION

(11) **EP 1 821 311 B1**
(45) Date of publication and mention of the grant of the patent: **15.04.2009**
(21) Application number: 07102164.6
(22) Date of filing: 12.02.2007
(51) Int. Cl.: G11C 11/16, G11C 19/08

(54) **Magnetic memory device using magnetic domain motion**
Magnetspeichervorrichtung unter Verwendung der Bewegung magnetischer Domänen
Dispositif de mémoire magnétique utilisant un mouvement de domaine magnétique

(30) Priority: 17.02.2006 KR 20060015623
(43) Date of publication of application: 22.08.2007
(73) Proprietor: Samsung Electronics Co., Ltd., Suwon-si, Gyeonggi-Do (KR)
(72) Inventor: Kim, Tae-wan c/o Samsung Advanced Institute of Technology, Gyeonggi-do (KR); Kim, Kee-won c/o Samsung Advanced Institute of Technology, Gyeonggi-do (KR); Cho, Young-jin c/o Samsung Advanced Institute of Technology, Gyeonggi-do (KR); Hwang, In-jun c/o Samsung Advanced Institute of Technology, Gyeonggi-do (KR)
(74) Representative: Greene, Simon Kenneth

(56) References cited:
- EP-A- 1 320 102
- EP-A- 1 708 257
- US-A1- 2004 251 232

## Description

### BACKGROUND OF THE INVENTION

The present invention relates to a magnetic memory, and more particularly, to a magnetic memory for writing or reading a plurality of data bits using a magnetic domain motion.

Magnetic memory for storing information is roughly classified into memory devices and storage devices. The memory devices focus on increasing solid state performance, while the storage devices focus on increasing capacity.

A magnetic random access memory (MRAM) is a non-volatile magnetic memory and a new solid state magnetic memory that uses a magnetic resistance effect based on spin-dependent conduction peculiar to nanomagnetic material. That is, the MRAM uses giant magnetoresistance (GMR) or tunnel magnetoresistance (TMR) generated as spin, which is a degree of freedom of an electron, has a great influence on electron delivery.

The GMR is a resistance difference generated when ferromagnetic materials located with a non-magnetic material interposed therebetween have the same magnetization direction or different magnetization directions as in an adjoining arrangement of ferromagnetic materials with a metallic non-magnetic material interposed therebetween. The TMR is resistance where a current easily flows through, when two ferromagnetic materials have the same magnetization direction in an adjoining arrangement of ferromagnetic materials with an insulator interposed therebetween compared to when the two ferromagnetic materials have different magnetization directions. Since the MRAM using the GMR has a relatively small resistance difference due to a magnetization direction, a large voltage difference cannot be achieved. Also, since the MRAM has a disadvantage in that a size of a metal oxide semiconductor field effect transistor (MOSFET) that is combined with a GMR layer in order to form a cell should increase, research for pursuing commercialization of MRAM using a TMR layer is currently being carried out more actively.

The MRAM may consist of a transistor, which is a switching device, and a magnetic tunnel junction (MTJ) cell in which data is stored. Generally, the MTJ cell may consist of a pinned ferromagnetic layer having a pinned magnetization direction, a free ferromagnetic layer whose magnetization direction may be parallel or anti-parallel to the pinned magnetization direction of the pinned ferromagnetic layer, and a non-magnetic layer located between the pinned ferromagnetic layer and the free ferromagnetic layer, magnetically separating the ferromagnetic layers.

However, since the MTJ stores one-bit data per cell, there is a limitation to the amount of data storage capacity of the MRAM that can be increased. Therefore, a new storage technology is required in order to increase an information storage capacity of a magnetic memory such as the MRAM.

EP 1320102 describes an MRAM using magnetic domain drag. Each magnetic domain has an in-plane magnetization direction relative to the recording layer.

### SUMMARY OF THE INVENTION

The present invention provides a magnetic memory device for forming a plurality of magnetic domains each having a perpendicular magnetization direction on a recording layer and storing or reading a plurality of data bits using a magnetic domain motion.

According to an aspect of the present invention, there is provided a magnetic memory device according to claim 1.

The recording layer may be a magnetic domain strip formed of an amorphous magnetic material having a perpendicular magnetization direction.

The recording layer may include an alloy of a rare earth element- transition metal.

The rare earth element used for forming the recording layer may be at least one selected from the group consisting of Tb, Gd, and Eu.

The transition metal used for forming the recording layer may be at least one selected from the group consisting of Co, Fe, Mn, and Ni.

The reference layer may have one of a perpendicular magnetization direction and an in-plane magnetization direction.

The reference layer may be formed of the same material as that of the recording layer.

The data bit region may consist of a single magnetic domain.

The memory device may further include a non-magnetic layer between the reference layer and the recording layer.

The non-magnetic layer may be one of a conduction layer and an insulation layer serving as a tunneling barrier.

The writing signal may be a pulse type switching current.

The reading signal may be a pulse current smaller than the switching current.

The inputting of at least one of the switching current and the reading pulse current, and the inputting of the magnetic domain motion signal may be performed in turns, so that a data storing or reading operation and a magnetic domain motion operation are performed in turns.

A magnetic domain motion may be performed by a data bit region unit.

A magnetic domain motion may be performed by a data bit region unit, and a data storing or reading operation and a magnetic domain motion operation are performed in turns.

The memory device may further include a buffer cell located on one side of the data storage cell and adjoining the data storage cell to store data moved to the outside of a region of the data storage cell due to a magnetic domain motion.

A plurality of data storage cells may be formed, and the buffer cell may be located between two adjacent data storage cells, and at least one first input portion may be formed per data storage cell.

A plurality of data storage cells may be formed in an array, and at least one first input portion may be formed per data storage cell.

### BRIEF DESCRIPTION OF THE DRAWINGS

The above and other features and advantages of the present invention will become more apparent by describing in detail exemplary embodiments thereof with reference to the attached drawings in which:
FIG. 1 is a schematic view illustrating a data storage cell and a magnetic memory having the same according to an embodiment of the present invention;
FIG. 2 is a view illustrating transmitted light intensity measured when a perpendicular magnetic field is applied, by using a magnetic optical kerr effect (MOKE), to five samples A, B, C, D, and E of a TbFeCo material having different composition ratios;
FIG. 3 illustrates photos obtained by performing microscopy using a microscope on a sample where a Tb₂₀Fe₇₀Co₁₀ layer is formed to a thickness of 20 nm and a W layer is formed to a thickness of 5 nm on the Tb₂₀Fe₇₀Co₁₀ layer;
FIGS. 4A through 4C are views illustrating when a switching current is applied to a fourth data bit region (a predetermined data bit region) of FIG. 1 so that a magnetization direction of the fourth data bit region is reversed, and the reversed magnetization direction of the fourth data bit region is moved to a fifth adjoining data bit region by a motion current;
FIGS. 5A and 5B are views illustrating when a pulse current for reading is applied to a fourth data bit region (a predetermined data bit region) of FIG. 1 so that data of the fourth data bit region is read, and the magnetization direction of the fourth data bit region is moved to a fifth adjoining data bit region by a motion current;
FIG. 6 is a schematic graph illustrating a magnetic domain motion current; pulse 1 (motion), a reading pulse current; pulse 2(reading), and a writing switching current pulse 2(writing) that are applied to a magnetic memory device according to an embodiment of the present invention; and
FIG. 7 is a schematic view of a magnetic memory device according to another embodiment of the present invention.

### DETAILED DESCRIPTION OF THE INVENTION

The present invention will now be described more fully with reference to the accompanying drawings, in which exemplary embodiments of the invention are shown.

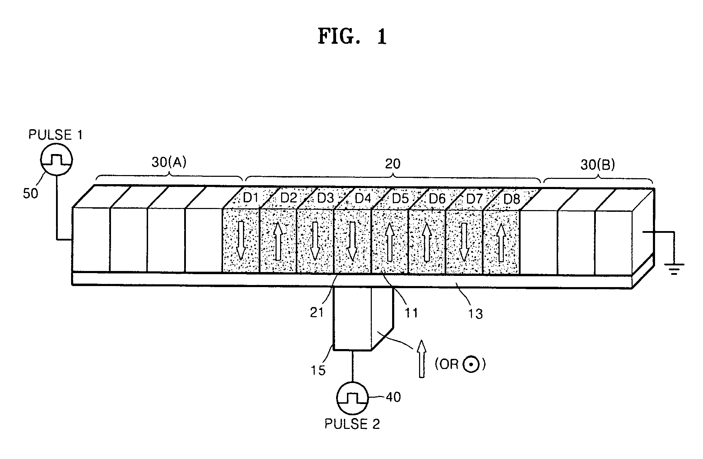

FIG. 1 is a schematic view illustrating a data storage cell and a magnetic memory having the same according to an embodiment of the present invention.

Referring to FIG. 1, the data storage cell 20 includes a recording layer 11 having a switchable magnetization direction for storing a plurality of data bits and formed a plurality of magnetic domains having a perpendicular magnetization direction, and a reference layer 15 corresponding to a portion of the recording layer 11. A non-magnetic layer 13 may be formed between the reference layer 15 and the recording layer 11. Although the non-magnetic layer 13 is formed over an entire surface of the recording layer 11 in FIG. 1, the non-magnetic layer 13 may be formed on just an upper surface of the reference layer 15.

The recording layer 11 has a switchable perpendicular magnetization direction and includes magnetic domain walls. An array of a plurality of magnetic domains exists in the recording layer 11 by existence of these magnetic domain walls. The recording layer 11 is formed in order to store a plurality of data bits in an array. For this purpose, the recording layer 11 may be formed in a magnetic domain strip.

In the data storage cell 20, data storing or stored data reading may be performed by a unit of area of the recording layer 11 that corresponds to an effective size of the reference layer 15. The effective size of the reference layer 15 determines a size of a one data bit region of the recording layer 11.

Therefore, the recording layer 11 may be formed having a length as long as a multiple of the number of data bit regions with respect to the effective size of the reference layer 15, that is, a width of a magnetic domain motion. Accordingly, an array of a plurality of data bit regions is provided to the recording layer 11 by a unit having an effective size of the reference layer 15, so that a plurality of data bits can be stored in an array.

On the other hand, since it is preferred that only a single magnetic domain is present within one data bit region, a magnetic domain formed in the recording layer 11 may be formed to a size equal to or greater than the effective size of the reference layer 15.

The recording layer 11 is formed of a perpendicular magnetic anisotropic material, particularly, an amorphous magnetic material (i.e., an amorphous ferrimagnetic material or amorphous ferromagnetic material) so that the recording layer 11 may have a perpendicular easy axis and thus have a perpendicular magnetization direction. The recording layer 11 may be formed as a magnetic domain strip.

For example, the recording layer 11 may be formed of a material including an alloy of a rare earth element-transition metal.

The rare earth element used for forming the recording layer 11 may be selected from the group consisting of Tb, Gd, and Eu.

The transition metal used for forming the recording layer 11 may be selected from the group consisting of Co, Fe, Mn, and Ni.

The recording layer 11 may be formed of, for example, TbFeCo to have a perpendicular easy axis.

When the recording layer 11 of a magnetic domain strip having a perpendicular magnetization direction is formed using the amorphous magnetic material, an artificial magnetic domain forming process is not needed, and a magnetic domain corresponding to a data bit region having a small size, e.g., a nano scale size, can be naturally formed.

In the case of a soft magnetic material having an in-plane magnetization direction, a magnetic domain is not stabilized and is apt to be divided into multi domains when the size of a magnetic domain becomes small. Therefore, when the soft magnetic material having the in-plane magnetization direction is used, it is difficult to naturally form one data bit region storing one-bit data using a single domain. Therefore, when the recording layer is formed using the soft magnetic material having the in-plane magnetization direction, notches should be artificially formed in the recording layer 11 in order that one magnetic domain is present in one data bit region and thus an array of a plurality of data bit regions is formed in the recording layer 11.

On the other hand, according to the data storage cell 20 of the present invention, since the recording layer 11 is formed of an amorphous magnetic material so that the recording layer 11 may have a perpendicular magnetization direction, it is possible to stably form only one magnetic domain per one data bit region even when the size of the magnetic domain is reduced to a degree of a nano scale. Therefore, it is possible to naturally form a magnetic domain corresponding to a data bit region having a small size, e.g., a nano scale size.

When the recording layer 11 is formed of an amorphous magnetic material having a perpendicular magnetization direction, such as a material including an alloy of a rare earth element-transition metal, the recording layer 11 has considerably high coercive force compared to that of a soft magnetic material. Therefore, the magnetic domain can be naturally formed to a size corresponding to an effective size of the reference layer 15, and the magnetic domain can be stably maintained.

On the other hand, the reference layer 15 is a pinned layer having a pinned magnetization direction, and has an effective size corresponding to one data bit region of the recording layer 11.

The reference layer 15 may have one of a pinned in-plane magnetization direction and a pinned perpendicular magnetization direction.

For example, the reference layer 15 may be formed of a general ferromagnetic material so that the reference layer may have a predetermined in-plane magnetization direction.

As another example, the reference layer 15 may be formed of substantially the same magnetic material (such as an alloy of a rare earth element-transition metal) as that of the recording layer 11 so that the reference layer 15 may have a perpendicular magnetization direction. For example, the reference layer 15 may be formed of TbFeCo. At this point, since the recording layer 11 should have a switchable magnetization direction and the reference layer 15 should have a pinned magnetization direction, the recording layer 11 should have a relatively low coercive force, and the reference layer 15 should have a relatively high coercive force. The coercive force may be controlled by changing composition ratios of elements used for forming the reference layer 15 and the recording layer 11.

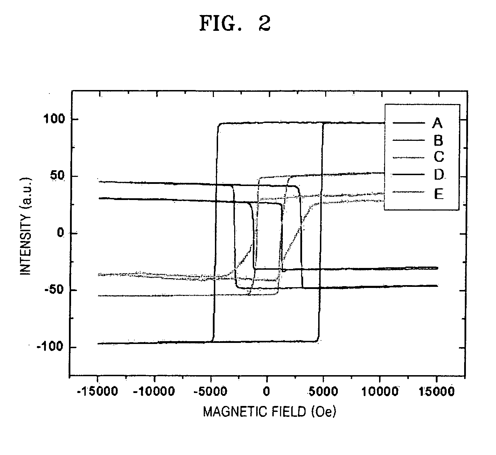

FIG. 2 is a view illustrating transmitted light intensity measured when a perpendicular magnetic field is applied, by using a magnetic optical kerr effect (MOKE), to five samples A, B, C, D, and E of a TbFeCo material having different composition ratios. In FIG. 2, a horizontal axis represents a perpendicular magnetic field (unit: Oe), and a vertical axis represents transmitted light intensity (unit: arbitrary unit(a.u.)).

FIG. 2 shows results obtained by measuring light intensity as a polarization of transmitted light changes depending on a magnetization direction. The results shown in FIG. 2 are obtained by applying a perpendicular magnetic field and show that a material TbFeCo has a perpendicular magnetization characteristic (perpendicular easy axis). A curve shown in FIG. 2 corresponds to a magnetic hysteresis curve and shows that a sample D having a large interval between curves has a high coercive force. The sample D may be used for the reference layer 15. The rest samples A, B, C, and E have a low coercive force compared to the sample D and thus may be used for the recording layer 11.

Here, the samples A and B are samples where a TbFeCo layer is formed to a thickness of 20 nm and a W layer is formed to a thickness of 5 nm on the TbFeCo layer (No-under layer/TbFeCo (20 nm)/W (5 nm)). The samples C and D are samples where an Al layer is formed to a thickness of 10 nm, a TbFeCo layer is formed to a thickness of 20 nm on the Al layer, and a W layer is formed to a thickness of 5 nm on the TbFeCo layer (Al (10 nm)/TbFeCo (20 nm)/W (5 nm)). The sample E is a sample where an Al layer is formed to a thickness of 10 nm, a TbFeCo layer is formed to a thickness of 100 nm on the Al layer, and a W layer is formed to a thickness of 2-3 nm on the TbFeCo layer (Al (10 nm)/TbFeCo (100 nm)/W (2-3 nm)).

The element composition ratios of the samples A, B, C, D, and E are A:Tb20Fe70Co10, B:Tb23Fe67Co10, C:Tb20Fe70Co10, D:Tb18Fe72Co10, and E:Tb16Fe74Co10.

Referring to FIG. 2, since the strength of the coercive force may be changed by changing the element composition ratios of TbFeCo, the recording layer 11 and the reference layer 15 can each be formed of the same material. At this point, the element composition ratios of TbFeCo are optimized so that the recording layer 11 has a relatively low coercive force, while the reference layer 15 has a relatively high coercive force.

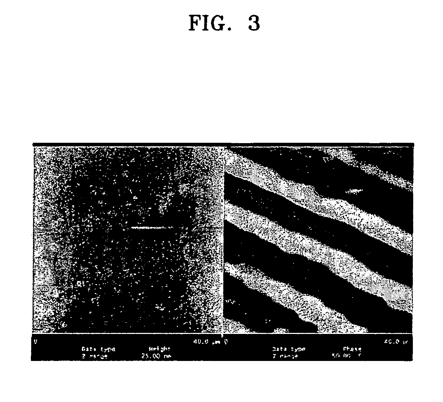

FIG. 3 illustrates photos where magnetic domains are formed in a sample (No-under layer/TbFeCo (20 nm)/W (5 nm)) where a Tb₂₀Fe₇₀Co₁₀ layer is formed to a thickness of 20 nm and a W layer is formed to a thickness of 5 nm on the Tb₂₀Fe₇₀Co₁₀ layer. The left side of FIG. 3 shows an atomic force microscopy (AFM) photo of the sample, and the right side of FIG. 3 shows a magnetic force microscopy (MFM) photo of the sample. In the sample shown in FIG. 3, a perpendicular coercive force Hc_{┴} is 1.66 kOe, and a saturated magnetization force Ms is 280 emu/cc.

In an MFM test, measurement is performed under conditions where a restrictive magnetic field is applied to an entire sample and then the applied magnetic field is removed (zero-field), that is, a natural state is achieved. In the MFM photo, a bright portion is a magnetic domain that has been magnetized in a direction extending out of the paper (referred to as a first magnetic domain), and a dark portion is a magnetic domain that has been magnetized in a direction entering the paper (referred to as a second magnetic domain). Since the first and second magnetic domains are formed in turns, the above-described recording layer 11 can be obtained by forming an array of these magnetic domains as a magnetic domain strip. Referring to FIG. 3, each of the first and second magnetic domains is not divided into multi domains but is maintained as a single domain.

Referring again to FIG. 1, the data storage cell 20 according to an embodiment of the present invention may further include a non-magnetic layer 13 between the reference layer 15 and the recording layer 11. The non-magnetic layer 13 may be one of a conduction layer such as Cu and an insulation layer serving as a tunneling barrier, such as an aluminum oxide layer.

In FIG. 1, eight data bit regions each having a size corresponding to a size of the reference layer 15 are formed so that the data storage cell 20 may store 8-bit data. The number of data bit regions may be increased as desired. In FIG. 1, D1, D2, D3, D4, D5, D6, D7, and D8 are first to eighth data bit regions constituting the data storage cell 20.

In the magnetic memory device 10 according to an embodiment of the present invention, each of the plurality of data bit regions D1, D2, D3, D4, D5, D6, D7, and D8 may be formed of a single magnetic domain where a magnetic domain wall is present at both edges of the magnetic domain.

The magnetic memory device 10 according to an embodiment of the present invention, having the data storage cell 20 as above described, will be described below.

Referring again to FIG. 1, the magnetic memory device 10 includes the data storage cell 20 to store a plurality of data bits, at least one first input portion 40 inputting at least one (Pulse 2) of a writing signal and a reading signal, and a second input portion 50 inputting a magnetic domain motion signal (Pulse 1).

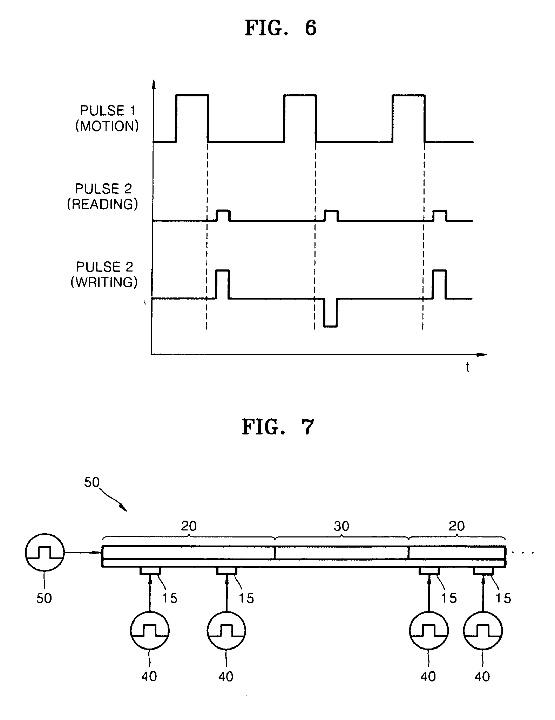

In the magnetic memory device 10 according to an embodiment of the present invention, an adjoining magnetic domain of the recording layer 11 is moved and a data bit, i.e., "0" or "1", is recorded in a predetermined magnetic domain, by reversing a magnetization direction of one of the magnetic domains, i.e., the predetermined magnetic domain located at a predetermined position corresponding to the reference layer 15 using spin transfer torque, i.e., current induced magnetic switching (CIMS), according to a magnetic domain motion signal (Pulse 1) applied through the second input portion 50, and a writing current signal (e.g., Pulse 2 (writing) in FIG. 6) applied, in synchronization with this magnetic domain motion signal (Pulse 1), through the first input portion 40.

Additionally, in the magnetic memory device 10 according to an embodiment of the present invention, a magnetic domain is moved, and data stored in a magnetic domain is read by applying (e.g., using spin tunnelling) a reading signal, i.e., a reading pulse signal, to the recording layer 11 and the reference layer 15, according to a magnetic domain motion signal (Pulse 1) applied through the second input portion 50, and a reading signal (e.g., Pulse 2 (reading) in FIG. 6) applied, in synchronization with this motion signal (Pulse 1), through the first input portion 40.

In FIG. 1, Pulse 2 is a writing signal or reading signal.

On the other hand, the first input portion 40 is electrically connected to at least one data bit region of the recording layer 11 and the reference layer 15. FIG. 1 shows that the first input portion 40 is electrically connected to the reference layer 15 and a single data bit region (a predetermined data bit region 21, for example) of the recording layer 11 that is located on the reference layer 15.

A writing signal is input to the recording layer 11 and the reference layer 15 through the first input portion 40, and a magnetization direction of the predetermined data bit region 21 of the recording layer 11 that is located on the reference layer 15 is designated according to this writing signal. In FIG. 1, the data storage cell 20 has an array of first to eighth data bit regions D1, D2, D3, D4, D5, D6, D7 and D8, and the predetermined data bit region 21 electrically connected to the first input portion 40 becomes the fourth data bit region D4 located on the reference layer 15.

When a writing signal is input through the first input portion 40, a magnetization direction of the fourth data bit region D4 is determined according to this writing signal. For example, when the fourth data bit region D4 has a predetermined magnetization direction, the magnetization direction of the fourth data bit region D4 is reversed or maintains an original magnetization direction depending on an applied writing signal. The magnetization direction designated in this manner represents a recorded data bit.

Referring to FIG. 6, the writing signal may be a pulse-type switching current. A magnetization direction of a predetermined data bit region 21, e.g., the fourth data bit region D4 of the recording layer 11 that is located on the reference layer 15, is selectively switched depending on the polarity of this switching current, and a data bit to be stored, i.e., "0" or "1", is stored in the predetermined data bit region 21.

For example, assuming that the reference layer 15 has a perpendicular magnetization direction and a data bit is designated as "0" when a perpendicular magnetization direction of a predetermined data bit region 21 becomes the same as the magnetization direction of the reference layer 15, i.e., parallel to the perpendicular magnetization direction of the reference layer 15, when a switching current is applied, a data bit may be designated as "1" when the predetermined data bit region 21 has a perpendicular magnetization direction opposite to the perpendicular magnetization direction of the reference layer 15 when a switching current having an opposite polarity is applied. Consequently, data is stored by changing the switching current's polarity to allow the magnetization direction of the predetermined data bit region 21 to be the same as that of the reference layer 15 or to be opposite that of the reference layer 15. In FIG. 1, arrows marked on the first to eighth data bit regions D1, D2, D3, D4, D5, D6, D7 and D8 represent perpendicular magnetization directions.

Here, assuming that the reference layer 15 has an in-plane magnetization direction, e.g., a magnetization direction is directed to the right and a data bit is designated as "0" when a predetermined switching current is applied and a perpendicular magnetization direction of a predetermined data bit region 21 is directed to "up", then a data bit may be designated as "1" when a switching current having an opposite polarity is applied and the predetermined data bit region 21 has a perpendicular magnetization direction directed to "down". Consequently, data is stored by changing the polarity of a switching current to allow the perpendicular magnetization direction of the predetermined data bit region 21 to become "up" or "down". In FIG. 1, arrows marked on the first to eighth data bit regions D1, D2, D3, D4, D5, D6, D7 and D8 represent perpendicular magnetization directions.

Here, whether the reference layer 15 has a perpendicular magnetization direction or an in-plane magnetization direction, whether a perpendicular magnetization direction is "up" or "down" when the reference layer 15 has the perpendicular magnetization direction, and whether an in-plane magnetization direction is "right" or "left" when the reference layer 15 has the in-plane magnetization direction, are determined in advance. Therefore, assuming that a data bit is designated as "0" and "1" when the perpendicular magnetization direction of the recording layer 11 is "up" and "down", respectively, with respect to a predetermined magnetization direction of the reference layer 15, it is possible to store desired data by switching the perpendicular magnetization direction of the predetermined data bit region 21 contained in the recording layer 11.

On the other hand, when stored data is to be read, a reading signal, e.g., a reading pulse current illustrated in FIG. 6, is input to the predetermined data bit region 21 of the recording layer 11 and the reference layer 15 through the first input portion 40. At this point, the reference layer 15, the predetermined data bit region 21 of the recording layer 11 that is located on the reference layer 15, and the non magnetic layer 13 located therebetween constitute a magnetic tunnel junction (MTJ) cell. Therefore, the intensity of passing current or resistance changes depending on a perpendicular magnetization direction of the predetermined data bit region 21 of the recording layer 11 with respect to the magnetization direction of the reference layer 15. Data is read using such a change. Here, a separate reference layer and an input portion may be provided in order to read data.

Referring to FIG. 6, the reading pulse current may be a pulse current smaller than the switching current for writing. This reading pulse current is applied in synchronization with the domain motion signal. Therefore, stored data according to a magnetization direction of a predetermined data bit region 21 located on the reference layer 15may be read.

The second input portion 50 is electrically connected to the recording layer 11 in order to move data (i.e., in-plane magnetization or perpendicular magnetization) stored in a data bit region of the recording layer 11 to an adjoining data bit region. A magnetization direction of a magnetic domain is moved to an adjoining magnetic domain according to a motion signal (Pulse 1) input through the second input portion 50. Accordingly, bit data contained in a predetermined data bit region is moved to an adjacent data bit region. Such a motion is called a magnetic domain motion.

The magnetic domain motion signal (Pulse 1) may be a pulse current input with a constant period. The magnetic domain motion signal (Pulse 1) may be input so that the magnetic domain motion is performed by a data bit region unit including at least one magnetic domain. Here, since the magnetic domain motion substantially moves a magnetization direction of a predetermined magnetic domain to an adjoining magnetic domain, the motion signal (Pulse 1) may be continuously applied while the magnetic domain motion is performed by a data bit region unit, and periodically applied so that the magnetic domain motion is performed by a data bit region unit.

A writing switching current or reading switching current, and a motion signal may be input in turns. Therefore, a data writing operation or stored data reading operation, and a magnetic domain motion are performed in turns, so that a plurality of data bits are sequentially recorded in a plurality of data bit regions, or a plurality of data bits stored in the plurality of data bit regions are sequentially read.

On the other hand, the magnetic memory device 10 may further include the buffer cell 30 that adjoins the data storage cell 20 at at least one side of the data storage sell 20 in order to store data moved to the outside of a region of the data storage cell 20 due to a magnetic domain motion.

When the data storage cell 20 has n data bit regions, the buffer cell 30 may have at least n or n-1 data bit regions. That is, the number of the data bit regions contained in the buffer cell 30 may be at least the same number of the data bit regions contained in the data storage cell 20 or may be a small number that is about 1 less than the number of the data bit regions. Physical properties of the recording layer 11 located in the data storage cell 20 and the buffer cell 30 are substantially the same. FIG. 1 shows an example where a central portion of the recording layer 11 is used as the data storage cell 20 and both side portions of the recording layer 11 are used as the buffer cell 30. Since a writing or reading operation is not directly performed on the buffer cell 30, the buffer cell 30 may include only the recording layer 11, or include a layer structure consisting of the recording layer 11 and the non-magnetic layer 13 located beneath it. Also, in the magnetic memory device 10 according to an embodiment of the present invention, the buffer cell 30 may have substantially the same layer structure as that of the data storage cell 20, that is, a layer structure that includes the reference layer 15, even without a signal input to the reference layer 15 of the buffer cell 30.

In FIG. 1, a data writing or reading operation is performed on a fourth data bit region D4, which is a fourth region of eight data bit regions D1, D2, D3, D4, D5, D6, D7 and D8 of the data storage cell 20, and a first portion A and a second portion B of the buffer cell 30 are respectively provided on either side of the data storage cell 20. FIG. 1 shows that the first portion A of the buffer cell 30 having four data bit regions to the left side of the data storage cell 20, and the second portion B of the buffer cell 30 having three data bit regions to the right side of the data storage cell 20 are formed in consideration of the case where a magnetic domain motion is performed from left to right during a data reading operation. For data contained in eight data bit regions D1, D2, D3, D4, D5, D6, D7 and D8 of the data storage cell 20, a data reading operation starts with the eighth data bit region D8 moved to the left so that data of the eighth data bit region D8 is positioned at a fourth data bit region D4, and a motion operation and a reading operation are performed in turns while the data is moved to the right, so that the data contained in the eight data bit regions D1, D2, D3, D4, D5, D6, D7 and D8 can be sequentially read.

Though FIG. 1 shows an example where the reference layer 15 is formed on a middle portion of the data storage cell 20 and thus a data writing or reading operation is performed on the middle portion of the data storage cell 20, the present invention is not limited to this particular example and various modifications can be made.

For example, a data writing or reading operation is performed on a first data bit region D1 of the data storage cell 20, and the buffer cell 30 having at least the same number of the data bit regions contained in the data storage cell 20 or a small number that is 1 less than the number of the data bit regions may be formed adjacently to a data bit region of the data storage cell 20 where the data writing or reading operation starts (for example, when the data writing or reading operation starts at a first data bit region D1, the left side of the first data bit region D1; and when the data writing or reading operation starts at an eighth data bit region D8, the right side of the eighth data bit region D8) or may be formed at both side of the data storage cell 20. Since this modification can be easily deduced from the structure shown in FIG. 1, detailed illustration thereof will be omitted.

When the buffer cell 30 is formed only on the right or left of the data storage cell 20, data contained in the data storage cell 20 is moved to the buffer cell 30, and then the data reading operation is performed. Then, a magnetic domain motion performed during the data reading operation and a magnetic domain motion performed during the data wiring operation may be performed in the same direction. Also, the data reading operation may be simultaneously performed while data contained in the data storage cell 20 is moved to the buffer cell 30. In this case, a magnetic domain motion performed during the data reading operation and a magnetic domain motion performed during the data writing operation are performed in mutually opposite directions.

When n data bits are stored in the data storage cell 20, the number of data bit regions of the buffer cell 30 may be one data bit region smaller than that of the data storage cell 20. That is, the buffer cell 30 may be formed to store (n-1) data bits. This reason is as follows. Since one data bit can be always stored in a data bit region, i.e., a predetermined data bit region 21 of the data storage cell 20 where the data writing or reading operation is performed, the buffer cell 30 should temporarily store only (n-1) data bits.

When the buffer cells 30 are formed on both sides of the data storage cell 20, data contained in the data storage cell 20 can be read while a magnetic domain motion is performed without moving the data to the buffer cell 30. At this point, a magnetic domain motion performed during the data reading operation and a magnetic domain motion performed during the data writing operation are performed in mutually opposite directions. Even in this case, when n data bits are stored in the data storage cell 20, the number of data bit regions stored in the buffer cells 30 formed on both sides of the data storage cell 20 may be one data bit region smaller than that of the data storage cell 20.

On the other hand, although the magnetic memory device 10 according to an embodiment of the present invention has the buffer cell 30 adjoining the data storage cell 20 in the above descriptions, the magnetic memory device 10 may consist of only the data storage cell 20 without the buffer cell 30. In this case, the data storage cell 20 further includes data bit regions serving as a buffer in addition to the data bit regions for storing a number of bits. For example, when n data bits are to be stored, the data storage cell 20 may include at least 2n or 2n-1 data bit regions.

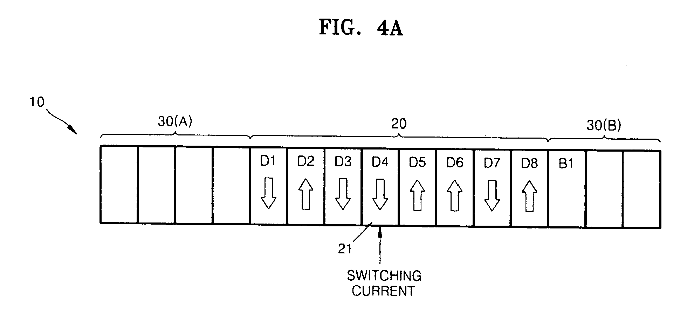

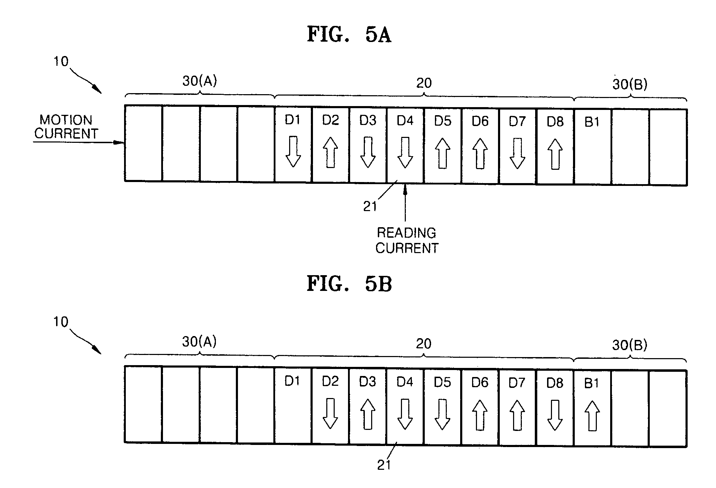

In the magnetic memory device 10 having the above-described structure according to an embodiment of the present invention, a writing switching current or reading switching current, and a motion current may be input in turns. Therefore, a data writing operation or stored data reading operation, and a magnetic domain motion are performed in turns. A data writing operation or data reading operation in the magnetic memory device 10 according to an embodiment of the present invention will be described below with reference to FIGS. 4A through 4C, and 5A and 5B.

FIGS. 4A through 4C are views illustrating when a switching current is applied to a fourth data bit region D4 (a predetermined data bit region 21) of FIG. 1 so that a perpendicular magnetization direction of the fourth data bit region D4 is reversed, and the reversed perpendicular magnetization direction of the fourth data bit region D4 is moved to a fifth adjoining data bit region D5 by a motion current. FIGS. 5A and 5B are views illustrating when a reading pulse current is applied to a fourth data bit region D4 (a predetermined data bit region 21) of FIG. 1 so that data of the fourth data bit region D4 is read, and the perpendicular magnetization direction of the fourth data bit region D4 is moved to a fifth adjoining data bit region D5 by a motion current. FIG. 6 is a schematic graph illustrating a magnetic domain motion current pulse 1, a reading pulse current pulse 2(reading), and a writing switching current pulse 2(writing) that are applied to a magnetic memory device 10 according to an embodiment of the present invention.

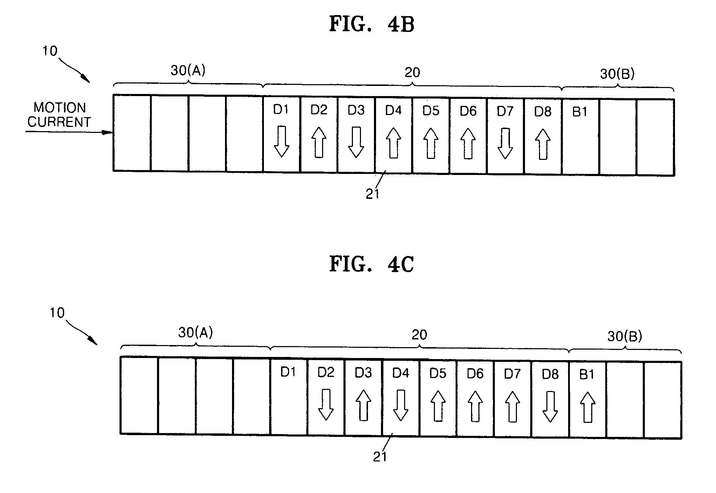

The data writing operation is performed in the following manner. When a switching current is applied to a fourth data bit region D4 as illustrated in FIG. 4A, a perpendicular magnetization direction of the fourth data bit region D4 is reversed as illustrated in FIG. 4B. After that, when a motion current is applied to the recording layer 11, perpendicular magnetization directions of respective data bit regions are moved to adjoining data bit regions, respectively, as illustrated in FIG. 4C. That is, the perpendicular magnetization directions of first to eighth data bit regions D1, D2, D3, D4, D5, D6, D7 and D8 of the data storage cell 20 illustrated in FIG. 4B, are moved, by one data bit region, to the second to eighth data bit regions D2, D3, D4, D5, D6, D7, D8 and a first data bit region B1 of a second portion B of the buffer cell 30, respectively, as illustrated in FIG. 4C.

As described above, the perpendicular magnetization direction of the predetermined data bit region 21 is designated, and data (perpendicular magnetization direction) of the predetermined data bit region 21 is moved to the adjoining data bit region, i.e., a fifth data bit region D5, after a predetermined time elapses, and a writing signal is input again to the predetermined data bit region 21 to designate a perpendicular magnetization direction again. Using a periodically applied motion current and a writing switching signal periodically applied in synchronization with the motion current illustrated in FIG. 6, designating process of the perpendicular magnetization direction and the motion process are performed in turns, so that a plurality of data bits are recorded in an array of the plurality of data bit regions of the recording layer 11. After the data recording operation is completed, a moved data storage position may be maintained or a motion signal moving the magnetic domains in the opposite direction is input, so that data in the first to eighth data bit regions D1, D2, D3, D4, D5, D6, D7, and D8 of the data storage cell 20 is stored.

The stored data reading operation is performed in the following manner. Referring to FIG. 5A, a reading current is applied to the fourth data bit region D4 so that data of the fourth data bit region D4 is read. After that, when a motion current is applied to the recording layer 11 as illustrated in FIG. 5B, magnetization directions of respective data bit regions are moved to adjoining data bit regions, respectively. That is, perpendicular magnetization directions of the first to eighth data bit regions D1, D2, D3, D4, D5, D6, D7, and D8 of the data storage cell 20 illustrated in FIG. 5A are moved, by one data bit region, to the second to eighth data bit regions D2, D3, D4, D5, D6, D7, D8 and the first data bit region B1 of the second portion B of the buffer cell 30, respectively, as illustrated in FIG. 5B.

As described above, the perpendicular magnetization direction of the predetermined data bit region 21 is read, and data (perpendicular magnetization direction) of the predetermined data bit region 21 is moved to the adjoining data bit region, i.e., the fifth data bit region D5, after a predetermined time elapses, and a reading signal is input again to the predetermined data bit region 21 to perform a data reading operation. Using a periodically applied motion current and a reading switching signal pulse current periodically applied in synchronization with the motion current illustrated in FIG. 6, the reading process and the motion process are performed in turns until reading of a plurality of data bits stored on the recording layer 11 is completed. After the data reading operation is completed, a moved data storage position may be maintained or a motion signal moving the magnetic domains in the opposite direction is input, so that data originally stored in the first to sixth data bit regions D1, D2, D3, D4, D5, D6, D7, and D8 of the data storage cell 20 is maintained.

During the reading operation, the reading pulse current is periodically applied in synchronization with a domain motion signal without polarity reversion as illustrated in FIG. 6. The amount of a current flowing through a tunnel barrier, and resistance therefrom when the reading pulse current is applied to the reference layer 15 and the predetermined data bit region 21 of the recording layer 11, differ depending on whether a perpendicular magnetization direction of the predetermined data bit region 21 of the recording layer 11 is "up" or "down". For example, resistance when the perpendicular magnetization direction of the predetermined data bit region 21 of the recording layer 11 is "down" is greater than resistance when the perpendicular magnetization direction of the predetermined data bit region 21 of the recording layer 11 is "up" in a case where a perpendicular magnetization direction of the reference layer 15 is "up". Data stored in the predetermined data bit region 21 is recognized using such a resistance difference.

In the above descriptions, the magnetic memory device 10 according to an embodiment of the present invention can incorporate a magnetic device capable of reading a plurality of data bits (i.e., an MTJ or GMR sensor) and a recording magnetic device using spin transfer torque into a single device, but the present invention is not limited to this particular embodiment. That is, the magnetic memory device 10 according to the present invention may be used as a magnetic device (i.e., an MTJ or GMR sensor) capable of reading a plurality of data bits using a magnetic domain motion, or may be also used as a recording magnetic device using spin transfer torque, capable of recording a plurality of data bits using the magnetic domain motion.

FIG. 7 is a schematic view of a magnetic memory device 100 according to another embodiment of the present invention. Referring to FIG. 7, the magnetic memory device 100 may include a plurality of data storage cells 20. In this case, the memory device 100 may further include a buffer cell 30 that adjoins the data storage cell 20 in order to store data moved to the outside of the data storage cell 20 due to a magnetic domain motion. At this point, at least one first input portion 40 is formed per data storage cell 20. When a plurality of data storage cells 20 are provided and at least one first input portion 40 is formed per data storage cell 20, a data storage capacity increases by the number of data storage cells 20, and a data storing or reading speed is accomplished that is the same or faster than that of the magnetic memory device 10 that includes a single data storage cell, according to an embodiment of the present invention.

FIG. 7 shows an example where a buffer cell 30 is formed between two data storage cells 20. In the structure where a plurality of data storage cells 20 are formed, buffer cells 30 may be formed in at least one position of a position located before a first data storage cell and a position located after a last data storage cell, and at a position located between two adjacent data storage cells.

Also, the example shown in FIG. 7 illustrates two reference layers 15 and two first input portions 40 formed for one data storage cell 20. When a plurality of first input portions 40 are formed for one data storage cell 20, a data storing or reading speed may be enhanced even more.

As another embodiment of the present invention, a magnetic memory device 100 may have a structure such that a plurality of reference layers 15 and first input portions 40 are formed for one data storage cell 20 and a writing signal and a reading signal are input through different first input portions 40. Also, the a writing signal may be input into a data storage cell 20, and a reading signal may be input into another data storage cell 20.

According to the magnetic memory device of the present invention, a recording layer having switchable magnetic direction and having a plurality of magnetic domains, and a reference layer corresponding to a portion of the recording layer and having a pinned magnetization direction are provided. Also, a data storage cell including an array of a plurality of data bit regions each consisting of a magnetic domain, is provided. The magnetic domain is formed by a unit of effective size of the reference layer on the recording layer. Since a data storing or reading operation and a magnetic domain motion moving data stored in a data bit region of the recording layer to an adjoining data bit region are performed in turns, it is possible to store or read a plurality of data bits.

A plurality of data bits can be stored in each cell to which the magnetic memory device of the present invention is applied, which remarkably increases a data storage capacity.

Furthermore, according to the data storage cell of the present invention, since the recording layer is formed of an amorphous magnetic material so that the recording layer may have a perpendicular magnetization direction, it is possible to stably form only one magnetic domain per one data bit region even when a size of the magnetic domain is reduced to a nano scale size. Therefore, it is possible to naturally form a magnetic domain corresponding to a data bit region having a small size, e.g., a nano scale size, and stably maintain the magnetic domain.

Therefore, the number of data bits that can be stored per unit length of the recording layer may be remarkably increased.

Accordingly, according to the present invention, a magnetic memory having a remarkably high data storage capacity can be realized.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A magnetic memory device (10) comprising:
a recording layer (11) having a plurality of magnetic domains each having a switchable magnetization direction;
a reference layer (15) corresponding to a portion of the recording layer and having a pinned magnetization direction,
wherein a data storage cell (20) storing an array of a data bits comprises the magnetic domain that corresponds to an effective area of the reference layer which is formed in the recording layer;
a first input portion (40) electrically connected to at least one data bit region (21) of the data storage cell and to the reference layer, and inputting at least one of a writing signal and a reading signal; and
a second input portion (50) electrically connected to the recording layer and inputting a magnetic domain motion signal to move data stored in the data bit region (21) of the recording layer to an adjoining data bit region;
**characterised in that** the magnetic domains in the recording layer have an easy axis perpendicular to the recording layer.

2. The memory device of claim 1, wherein the recording layer (11) is a magnetic domain strip formed of an amorphous magnetic material having a perpendicular magnetization direction.

3. The memory device of claim 2, wherein the recording layer (11) includes an alloy of a rare earth element-transition metal.

4. The memory device of claim 3, wherein the rare earth element used for forming the recording layer (11) is at least one selected from the group consisting of Tb, Gd, and Eu.

5. The memory device of claim 3 or 4, wherein the transition metal used for forming the recording layer (11) is at least one selected from the group consisting of Co, Fe, Mn, and Ni.

6. The memory device of any preceding claim, wherein the reference layer (15) has one of a perpendicular magnetization direction and an in-plane magnetization direction.

7. The memory device of any preceding claim, wherein the reference layer (15) is formed of the same material as that of the recording layer.

8. The memory device of any preceding claim, wherein the data bit region (21) consists of a single magnetic domain.

9. The memory device of any preceding claim, further comprising a non-magnetic layer (13) located between the reference layer and the recording layer.

10. The memory device of claim 9, wherein the non-magnetic layer (13) is a conduction layer.

11. The memory device of claim 9, wherein the non-magnetic layer (13) is an insulation layer serving as a tunneling barrier.

12. The memory device of any preceding claim, wherein the writing signal is a pulse type switching current.

13. The memory device of claim 12, wherein the reading signal is a pulse current smaller than the switching current.

14. The memory device of claim 13, wherein the inputting of one of the switching current and the reading pulse current, and the inputting of the magnetic domain motion signal are performed in turns, so that a data storing or reading operation and a magnetic domain motion operation are performed in turns.

15. The memory device of claim 14, wherein the magnetic domain motion is performed by a data bit region unit.

16. The memory device of any preceding claim, wherein a magnetic domain motion is performed by a data bit region unit, and a data storing or reading operation and a magnetic domain motion operation are performed in turns.

17. The memory device of any preceding claim, further comprising a buffer cell (30) located on at least one side of the data storage cell and adjoining the data storage cell to store data moved to the outside of a region of the data storage cell due to a magnetic domain motion.

18. The memory device of claim 17, wherein a plurality of data storage cells (20) are formed, and the buffer cell (30) is located between two adjacent data storage cells (20), and at least one first input portion is formed per data storage cell.

19. The memory device of any preceding claim, wherein a plurality of data storage cells (20) are formed in an array, and at least one first input portion is formed per data storage cell (20).

## Patentansprüche

1. Magnetspeicherbauelement (10), umfassend:
eine Aufzeichnungsschicht (11) mit einer Mehrzahl von magnetischen Domänen, wobei jede eine umschaltbare Magnetisierungsrichtung aufweist,
eine Referenzschicht (15), die einem Abschnitt der Aufzeichnungsschicht entspricht und eine gepinnte Magnetisierungsrichtung aufweist,
wobei eine Datenspeicherzelle (20), die eine Matrix von Datenbits speichert, die magnetische Domäne umfasst, die einem effektiven Bereich der Referenzschicht entspricht und in der Aufzeichnungsschicht gebildet ist,
einen ersten Eingabebereich (40), der mit mindestens einem Datenbitbereich (21) der Datenspeicherzelle und der Referenzschicht elektrisch verbunden ist und ein Schreibsignal und/oder ein Lesesignal eingibt, und
einen zweiten Eingabebereich (50), der mit der Aufzeichnungsschicht elektrisch verbunden ist und ein Verschiebungssignal der magnetischen Domäne eingibt, um im Datenbitbereich (21) der Aufzeichnungsschicht gespeicherte Daten in einen angrenzenden Datenbitbereich zu verschieben,
**dadurch gekennzeichnet, dass** die magnetischen Domänen in der Aufzeichnungsschicht eine leichte Achse senkrecht zur Aufzeichnungsschicht aufweisen.

2. Magnetspeicherbauelement nach Anspruch 1, wobei die Aufzeichnungsschicht (11) ein magnetischer Domänenstreifen ist, der aus einem amorphen magnetischen Material gebildet ist, das eine senkrechte Magnetisierungsrichtung aufweist.

3. Magnetspeicherbauelement nach Anspruch 2, wobei die Aufzeichnungsschicht (11) eine Legierung aus einem Seltenerdelement-Übergangsmetall aufweist.

4. Magnetspeicherbauelement nach Anspruch 3, wobei das zum Ausbilden der Aufzeichnungsschicht (11) verwendete Seltenerdelement mindestens eines ausgewählt aus der Gruppe bestehend aus Tb, Gd und Eu ist.

5. Magnetspeicherbauelement nach Anspruch 3 oder 4, wobei das zum Ausbilden der Aufzeichnungsschicht (11) verwendete Obergangsmetall mindestens eines ausgewählt aus der Gruppe bestehend aus Co, Fe, Mn und Ni ist.

6. Magnetspeicherbauelement nach einem der vorhergehenden Ansprüche, wobei die Referenzschicht (15) eine senkrechte Magnetisierungsrichtung oder eine Magnetisierungsrichtung in der Ebene aufweist.

7. Magnetspeicherbauelement nach einem der vorhergehenden Ansprüche, wobei die Referenzschicht (15) aus dem gleichen Material wie die Aufzeichnungsschicht gebildet ist.

8. Magnetspeicherbauelement nach einem der vorhergehenden Ansprüche, wobei der Datenbitbereich (21) aus einer einzelnen magnetischen Domäne gebildet ist.

9. Magnetspeicherbauelement nach einem der vorhergehenden Ansprüche, ferner umfassend eine nichtmagnetische Schicht (13), die zwischen der Referenzschicht und der Aufzeichnungsschicht gelegen ist.

10. Magnetspeicherbauelement nach Anspruch 9, wobei die nichtmagnetische Schicht (13) eine Leiterschicht ist.

11. Magnetspeicherbauelement nach Anspruch 9, wobei die nichtmagnetische Schicht (13) eine Isolierschicht ist, die als Tunnelungsbarriere dient.

12. Magnetspeicherbauelement nach einem der vorhergehenden Ansprüche, wobei das Schreibsignal ein Umschaltstrom vom Pulstyp ist.

13. Magnetspeicherbauelement nach Anspruch 12, wobei das Lesesignal ein Pulsstrom ist, der geringer ist als der Umschaltstrom.

14. Magnetspeicherbauelement nach Anspruch 13, wobei das Eingeben des Umschaltstroms oder des Lesepulsstroms und das Eingeben des Verschiebungssignals der magnetischen Domäne abwechselnd vorgenommen werden, so dass eine Datenspeicher- oder -leseoperation und eine Verschiebungsoperation der magnetischen Domäne abwechselnd ausgeführt werden.

15. Magnetspeicherbauelement nach Anspruch 14, wobei die Verschiebung der magnetischen Domäne um eine Datenbitbereichseinheit ausgeführt wird.

16. Magnetspeicherbauelement nach einem der vorhergehenden Ansprüche, wobei eine Verschiebung der magnetischen Domäne um eine Datenbitbereichseinheit ausgeführt wird und eine Datenspeicher- oder -leseoperation und eine Verschiebungsoperation der magnetischen Domäne abwechselnd ausgeführt werden.

17. Magnetspeicherbauelement nach einem der vorhergehenden Ansprüche, ferner umfassend eine Pufferzelle (30), die mindestens auf einer Seite der Datenspeicherzelle gelegen ist und an die Datenspeicherzelle angrenzt, um Daten zu speichern, die aufgrund einer Verschiebung der magnetischen Domäne zur Außenseite eines Bereichs der Datenspeicherzelle verschoben worden sind.

18. Magnetspeicherbauelement nach Anspruch 17, wobei eine Mehrzahl von Datenspeicherzellen (20) ausgebildet sind und die Pufferzelle (30) zwischen zwei benachbarten Datenspeicherzellen (20) gelegen ist und mindestens ein erster Eingabebereich pro Datenspeicherzelle ausgebildet ist.

19. Magnetspeicherbauelement nach einem der vorhergehenden Ansprüche, wobei eine Mehrzahl von Datenspeicherzellen (20) in einer Matrix ausgebildet ist und mindestens ein erster Eingabebereich pro Datenspeicherzelle (20) ausgebildet ist.

## Revendications

1. Dispositif de mémoire magnétique (10) comprenant :
une couche d'enregistrement (11) comportant une pluralité de domaines magnétiques ayant chacun une direction de magnétisation commutable ;
une couche de référence (15) correspondant à une partie de la couche d'enregistrement et ayant une direction de magnétisation verrouillée,
dans lequel une cellule de mémorisation de données (20) mémorisant une matrice de bits de données comprend le domaine magnétique qui correspond à une zone efficace de la couche de référence qui est formée dans la couche d'enregistrement ;
une première partie d'entrée (40) connectée électriquement à au moins une région de bits de données (21) de la cellule de mémorisation de données et à la couche de référence, et recevant au moins l'un d'un signal d'écriture et d'un signal de lecture ; et
une deuxième partie d'entrée (50) connectée électriquement à la couche d'enregistrement et recevant un signal de déplacement de domaine magnétique pour déplacer des données mémorisées dans la région de bits de données (21) de la couche d'enregistrement vers une région de bits de données contiguë ;
**caractérisé en ce que** les domaines magnétiques dans la couche d'enregistrement ont un axe aisé perpendiculaire à la couche d'enregistrement.

2. Dispositif de mémoire selon la revendication 1, dans lequel la couche d'enregistrement (11) est une bande de domaine magnétique constituée d'un matériau magnétique amorphe ayant une direction de magnétisation perpendiculaire.

3. Dispositif de mémoire selon la revendication 2, dans lequel la couche d'enregistrement (11) comprend un alliage d'un élément des terres rares et d'un métal de transition.

4. Dispositif de mémoire selon la revendication 3, dans lequel l'élément des terres rares utilisé pour former la couche d'enregistrement (11) est au moins l'un sélectionné dans le groupe consistant en le Tb, Gd et Eu.

5. Dispositif de mémoire selon la revendication 3 ou 4, dans lequel le métal de transition utilisé pour former la couche d'enregistrement (11) est au moins l'un sélectionné dans le groupe consistant en le Co, Fe, Mn et Ni.

6. Dispositif de mémoire selon l'une quelconque des revendications précédentes, dans lequel la couche de référence (15) a l'une d'une direction de magnétisation perpendiculaire et d'une direction de magnétisation dans le plan.

7. Dispositif de mémoire selon l'une quelconque des revendications précédentes, dans lequel la couche de référence (15) est constituée du même matériau que la couche d'enregistrement.

8. Dispositif de mémoire selon l'une quelconque des revendications précédentes, dans lequel la région de bits de données (21) consiste en un domaine magnétique unique.

9. Dispositif de mémoire selon l'une quelconque des revendications précédentes, comprenant en outre une couche non magnétique (13) située entre la couche de référence et la couche d'enregistrement.

10. Dispositif de mémoire selon la revendication 9, dans lequel la couche non magnétique (13) est une couche de conduction.

11. Dispositif de mémoire selon la revendication 9, dans lequel la couche non magnétique (13) est une couche d'isolement servant en tant que barrière de tunnellisation.

12. Dispositif de mémoire selon l'une quelconque des revendications précédentes, dans lequel le signal d'écriture est un courant de commutation du type impulsionnel.

13. Dispositif de mémoire selon la revendication 12, dans lequel le signal de lecture est un courant impulsionnel inférieur au courant de commutation.

14. Dispositif de mémoire selon la revendication 13, dans lequel l'application de l'un du courant de commutation et du courant impulsionnel de lecture, et l'application du signal de déplacement de domaine magnétique sont effectuées tour à tour, de sorte qu'une opération de mémorisation ou de lecture de données et une opération de déplacement de domaine magnétique sont effectuées tour à tour.

15. Dispositif de mémoire selon la revendication 14, dans lequel le déplacement de domaine magnétique est effectué par unité de région de bits de données.

16. Dispositif de mémoire selon l'une quelconque des revendications précédentes, dans lequel un déplacement de domaine magnétique est effectué par unité de région de bits de données, et une opération, de mémorisation ou de lecture de données et une opération de déplacement de domaine magnétique sont effectuées tour à tour.

17. Dispositif de mémoire selon l'une quelconque des revendications précédentes, comprenant en outre une cellule tampon (30) située au moins d'un côté de la cellule de mémorisation de données et contiguë à la cellule de mémorisation de données pour mémoriser des données déplacées à l'extérieur d'une région de la cellule de mémorisation de données du fait d'un déplacement de domaine magnétique.

18. Dispositif de mémoire selon la revendication 17, dans lequel une pluralité de cellules de mémorisation de données (20) sont formées, et la cellule tampon (30) est située entre deux cellules de mémorisation de données (20) adjacentes, et au moins une première partie d'entrée est formée par cellule de mémorisation de données.

19. Dispositif de mémoire selon l'une quelconque des revendications précédentes, dans lequel une pluralité de cellules de mémorisation de données (20) sont formées en une matrice, et au moins une première partie d'entrée est formée par cellule de mémorisation de données (20).
